# EUROPEAN PATENT SPECIFICATION

(11) **EP 3 166 201 B1**
(45) Date of publication and mention of the grant of the patent: **02.01.2019**
(21) Application number: 16196683.3
(22) Date of filing: 01.11.2016
(51) Int. Cl.: H02J 9/06, H05K 7/14

(54) **UNINTERRUPTIBLE POWER SUPPLY SYSTEM WITH GOOD SERVICEABILITY**
WARTUNGSFREUNDLICHES UNTERBRECHUNGSFREIES STROMVERSORGUNGSSYSTEM
SYSTÈME D'ALIMENTATION SANS INTERRUPTION FACILE À ENTRETENIR

(30) Priority: 04.11.2015 DE 102015118907
(43) Date of publication of application: 10.05.2017
(73) Proprietor: ABB Schweiz AG, 5400 Baden (CH)
(72) Inventor: Antoniazza, Alessandro, 28814 Cambiasca (IT); Molteni, Massimo, 22100 Como (IT); Gal, Zoltan, 6616 Losone (CH)
(74) Representative: ABB Patent Attorneys

(56) References cited:
- EP-A2- 0 854 410
- WO-A2-01/61822
- WO-A2-01/73914
- US-A1- 2005 162 836
- US-A1- 2008 144 294
- US-A1- 2015 076 915

## Description

### Technical Field

The present invention relates to the area of uninterruptible power supply systems. In particular, the present invention relates to modular uninterruptible power supply systems comprising a system rack for receiving at least one module with a functional unit of the uninterruptible power supply system, whereby the at least one module comprises a housing, and the at least one module is one out of a power module, an energy storage device; and a distribution assembly. Furthermore, the present invention relates to the area of service and maintenance of such an uninterruptible power supply system.

### Background Art

Different kinds of uninterruptible power supply (UPS) systems are known in the Art. For many applications, static or solid state uninterruptible power supply systems are used. Static UPS refer to UPS essentially without movable parts in its power path, in particular without a generator to provide power in case of a failure of the AC power supply. Solid state UPS include architectures such as dual conversion, also known as on-line UPS systems, and single conversion, also known as off-line UPS system.

In dual conversion UPS systems, the UPS system comprises a power supply side AC/DC converter unit, also referred to as rectifier, which is connected to the AC power supply, a load side DC/AC converter unit, also referred to as inverter, which is connected to the load, and a DC/DC converter unit, also referred to as battery converter, which is typically connected to a battery or other energy storage. The AC/DC converter unit, the DC/AC converter unit, and the DC/DC converter unit are connected to each other by a DC link. In normal operation, AC power from the AC power supply is provided through the AC/DC converter unit and the DC/AC converter unit to the load. In case of a failure of the AC power supply, the load is powered from the energy storage via the DC/DC converter unit and the DC/AC converter unit.

The AC/DC converter unit, the load side DC/AC converter unit, and the DC/DC converter unit are typically provided in a common housing as power module, which may comprise additional components. These components comprise large power capacitors, which are used to allow proper power conversion, e.g. an input AC filter or an output AC filter, and a capacitor bank for DC filtering and energy storing.

Furthermore, the UPS systems typically comprise a distribution assembly for making electrical connections e.g. to power supplies and the load. The distribution assembly typically comprises switches, fuses, terminals, and others. The UPS systems may also comprise a control interface, a user interface, or others.

In order to get the best performances with the minimum expenses, filter capacitors of the AC and DC filter are selected based on electrical, mechanical and environmental parameters as well as costs and reliability. Thanks to their high capacity density, DC electrolytic capacitors are suitable for DC filtering and energy storing. Unfortunately, DC electrolytic capacitors cannot be used for AC filtering. Polymeric film capacitors are a good choice for AC filtering but, if used for DC filtering and storing, they will increase the size and the cost of the DC filter. For the above reasons, DC electrolytic capacitors are typically used for DC capacitor banks while polymeric film capacitors are typically selected for AC filtering.

Despite the technology improvements of the last years, all high quality capacitors manufacturers provide a live time expectation for their capacitors. Since this parameter is statistically derived, it lacks sufficient accuracy to determine when a first capacitor in the system will fail. Moreover life expectation of capacitors is influenced by several parameters as operation conditions, e.g. voltage, current, or frequency, and environmental conditions, e.g. temperature or humidity, which are hugely difficult to monitor or define.

Similarly, also other components of the modules of the UPS system may undergo wearing and aging. Accordingly, there are different components of the UPS systems, which may require replacement.

In order to increase the mean time between failures (MTBF) of the UPS system, a regular replacement of these components can be required. Such a regular replacement increases system reliability and power quality. However, replacement is not free of charge because of component costs and replacement costs.

In single conversion UPS systems, the load is directly connected to the AC power supply. The single conversion UPS system comprises an energy storage device, which is typically a battery, a DC/AC converter unit, also referred to as inverter, and frequently a transformer. The energy storage device is electrically connected to the DC/AC converter unit to provide DC power thereto, and the DC/AC converter unit is electrically connected to the transformer, which transforms an AC voltage provided by the DC/AC converter unit to a required load voltage. A utility disconnect is typically provided to separate the DC/AC converter unit from the load side.

Some of the above principles in respect to modules and components also apply to single conversion UPS systems.
A UPS system according to the preamble of claim 1 is known from US 2005/162836 A1.

### Disclosure of Invention

It is an object of the present invention to provide an uninterruptible power supply system with increased serviceability, which can be maintained in an efficient way.

This object is achieved by the independent claims. Advantageous embodiments are given in the dependent claims.

In particular, the present invention provides a modular uninterruptible power supply system comprising a system rack for receiving at least one module with a functional unit of the uninterruptible power supply system, whereby the at least one module comprises a housing, and the at least one module is one out of a power module, an energy storage device; and a distribution assembly; whereby the at least one module comprises at least one component, which is removably connected within the housing of the respective module, the housing has at least one service opening, and the at least one service opening is arranged to remove and/or insert the at least one component through the at least one service opening.

The basic idea of the invention is to provide a modular uninterruptible power supply (UPS) system, which enables easy and quick access to components, which typically have a limited lifetime. Hence, based on the at least one service opening, the at least one component can be removed and/or inserted through the at least one service opening. This allows e.g. replacement of the at least one component in a reduced time. Access to the housing can be limited to an access from outside. Time-consuming operations like opening the housing of the modules can be omitted, so that replacement of the at least one component can be achieved in a short time. Overall, the modular UPS system enables an improved serviceability, since direct access to the at least one component is enabled from outside of the housing of the module. Accordingly, maintenance costs can be reduced at a negligible investment.

The at least one component can be any part of the UPS system, including boards, subassemblies or individual components, which are typically subject to periodical and non-periodical maintenance. The at least one component can be pre-tested for correct functionality and shipped ready to use. Hence, when replacement is required, no additional tests of the at least one component are required.

The at least one component can also be removably connected within the housing and extend in an inserted state over the boundaries of the housing. Important in this context is that the connection is made from outside through the at least one service opening. Hence, insertion of the at least one component through the at least one service opening does not require that the at least one component is fully enclosed by the boundaries of the housing.

The module may comprise a main printed circuit board (PCB), on which the at least one component is removably mounted. Also further parts of the respective module can be mounted on the main PCB.

The UPS system can be a standalone system or part of a system installation.

Furthermore, the modular UPS system can comprise any combination of modules. In particular, the UPS system can comprise multiple power modules, which are electrically connected in parallel, and/or multiple energy storage devices.

According to a modified embodiment of the invention the at least one component forms an overall functional block of the modular uninterruptible power supply system. The arrangement of overall functional blocks in components facilitates maintenance of the UPS system. Accordingly, the functional component can be replaced as a whole by a single replacement operation.

According to a modified embodiment of the invention the at least one component is one out of a total DC link capacitance or a subset, e.g. a rail of a multi-rail DC link, a filter capacitance of at least one power module function, e.g. AC/DC converter unit, DC/DC converter unit, or DC/AC converter unit, a functional disconnect for e.g. an AC/DC converter unit, DC/DC converter unit, or DC/AC converter unit, a system sub-function, e.g. an auxiliary power supply, a cooling device, e.g. a fan assembly or a thermal exchanger, a printed circuit board with a specific function within the UPS system, or any combination of the above functionality. These components area amongst components which typically undergo wearing and aging. Hence, replacement and maintenance for these components is required, either as a preventive measure or in case of failure. The capacitances are typically provided as capacitor banks with multiple capacitors and can therefore be replaced as a whole. Separating the capacitor banks from other system level components decrease spare parts cost. The capacitors are mounted on specific boards, which can be placed in easy to access positions within the housing, i.e. the service openings. The functional disconnect can be implemented as contactor, relay, switch, fuse or circuit breaker.

According to a modified embodiment of the invention the at least one component comprises a component printed circuit board, and the at least one component is removably connected within the housing with its component printed circuit board. The component printed circuit board (PCB) facilitates the replacement of e.g. functional groups, which can be commonly provided on the component PCB, so that replacement of the functional groups can be achieved by replacement of a single piece. The component PCB is preferably connected to a main PCB of the respective module.

According to a modified embodiment of the invention the at least one component and the at least one service opening comprise corresponding insertion means, which are adapted to ensure insertion of the at least one component into the at least one service opening in a pre-defined way. Hence, insertion of the component can be facilitated and hazardous or wrong installation can be prevented. The insertion means can comprise a design of the dimensions of the service opening or the physical space within the housing, which can be designed to form fit with the component. Hence, the component and the opening can have an asymmetric shape to avoid twisting of the component in the service opening and/or upon inserting into the service opening. The insertion means may comprise keys or obstacles preventing false orientation of the component in the service opening, or a physical form allowing only a single orientation of the component within the service opening.

According to a modified embodiment of the invention the at least one component and the at least one service opening comprise corresponding connection means, which are adapted to ensure electrical and/or mechanical connection of the at least one component in the at least one service opening in a pre-defined way. The connection means can be provided independently or together with the above insertion means to facilitate insertion of the component and to prevent hazardous or wrong installation of the component in the service opening of the housing. The connection means may comprise keys or obstacles preventing false orientation of the component, a symmetrical design allowing reversal of orientation maintaining safe operation, or a physical form allowing only a single orientation of the component within the service opening. Furthermore, the connection means can be provided with a coding, e.g. as a coded plug.

According to the invention the at least one component and/or the at least one service opening comprise detection means, which are adapted to detect an electrical and/or mechanical connection of the at least one component in the at least one service opening in a pre-defined way. Hence, operation of the UPS system can be controlled based on a detection result provided from the detection means. The detection means may comprise a sense wiring loop in cable harness, a correct assembly being detected by a voltage or a current or a handshake signal, a micro switch for mechanical position, and/or a false response to a control signal or command, e.g. excessive current or wrong amplitude or polarity of a voltage.

According to a modified embodiment of the invention the modular uninterruptible power supply system comprises a user interface and a control unit, which is connected to the detection means, whereby control unit is adapted to indicate a detection of the detection means of an electrical and/or mechanical connection of the at least one component in the at least one service opening in a pre-defined way, or vice versa, via the user interface. Hence, service personnel can receive an immediate feedback, if replacement of the component was successful, or if further action is required.

According to the invention the modular uninterruptible power supply system is adapted to changing into a safe system state upon a detection of the detection means of an electrical and/or mechanical connection of the at least one component in the at least one service opening different than in the pre-defined way. Hence, upon a detected false orientation, interconnect or system operation will result in an action that results in a maximally safe system state.

According to a modified embodiment of the invention the modular uninterruptible power supply system is adapted to perform at least one of the steps of opening of a controlled switch gear, turning off a converter unit of the power module and turning off a sub-function of the power module upon changing into a safe system state. This way, power of at least some of the components of the UPS system can be reduced or switched off, and power remaining in the UPS system can be easily handled. Hence, by only disconnecting at least one component of the UPS system, the component can be easily replaced. The replacement can be performed at substantially any time, which enables replacement of the at least one component without detailed knowledge on the operational state or others. The same refers to disconnection of a module out of multiple parallel modules, e.g. power module, so that all components of this module can be replaced without danger for a service personnel.

According to a modified embodiment of the invention the service opening comprises sealing means, which provide ingress protection to the service opening. With the ingress protection, the UPS system can be provide with an reliable ingress protection, so that the UPS system can fulfill a required level of ingress protection. The service openings may be sealed for an ingress protection level (IP) from none to hermetic to avoid leakage of melted materials, liquids, debris or dust into or out of the enclosures.

The ingress protection can at least partially be realized by a cover, which covers the UPS system. The cover is preferably a removable cover, which can be removed from the service opening. Furthermore, the cover can be provided integral with the component. Hence, usage of the cover can be facilitated.

According to a modified embodiment of the invention the component comprises an enclosure, which provides protection to elements of the component. The enclosure is in particular important in respect to transport of the component prior to a first installation into the module. Furthermore, the enclosure can prevent damage of other components within the system under an abnormal condition.

Further preferred, the replaceable component can be additionally sealed.

According to a modified embodiment of the invention the at least one service opening is arranged in a wall of the housing, which is accessible when the module is in an inserted position within the system rack. Hence, removing of the corresponding module from the system rack of the UPS system is not required when replacing a component thereof. Accordingly, the wall is preferably a front wall or a rear wall, which are typically accessible within the system rack. However, e.g. in standalone UPS systems, which require merely a single system rack, access from lateral wall can also be achieved. If the system rack comprises a respective side wall cover, it may be required to remove the side wall cover prior to accessing the component in the service opening in the side wall of the housing of the module.

According to a modified embodiment of the invention the at least one component is a calibrated component, which is calibrated to a pre-defined accuracy for at least one of a given current, voltage, temperature or other measurement circuitry included, in particular the component is calibrated to multiple pre-defined accuracies for at least one of a given current, voltage, temperature or other measurement circuitry included. Hence, the component is ready to use when provided for replacement of an existing component. The calibration can cover different values or ranges of current, voltage, or temperature, when the component is typically used in differently configured modules and/or UPS systems.

According to a modified embodiment of the invention the at least one service opening is provided having thermal conduction means, which are in thermal contact with the at least one component when inserted in the at least one service opening. The thermal conduction means are provided to dissipate heat form the component to the remainder of the module or to the outside of the module. In particular, when the component is provided integrally with a cover, the cover can be in thermal contact with functional elements of the component to dissipate heat out of the housing. Preferably, the thermal conduction means are provided as a thermal carpet at an internal side of the cover.

### Brief Description of Drawings

These and other aspects of the invention will be apparent from and elucidated with reference to the embodiments described hereinafter.

In the drawings:

- Fig. 1: shows an uninterruptible power supply system according to a first, preferred embodiment with a single power module, a distribution assembly, and an energy storage device as a schematic drawing in front and lateral view,
- Fig. 2: shows an uninterruptible power supply system according to a second embodiment with multiple power modules, a distribution assembly, and an energy storage device as a schematic drawing in front and lateral view,
- Fig. 3: shows a power module together with a distribution assembly in accordance with the first and second embodiment, in detail as a schematic drawing,
- Fig. 4: shows a distribution assembly in accordance with the first and second embodiment as a schematic drawing,
- Fig. 5: shows a power module in accordance with the first and second embodiment as a horizontally sectional drawing in a perspective view laterally from the top,
- Fig. 6: shows a power module in accordance with the first and second embodiment with capacitor banks removed from the service openings as a perspective view laterally from the bottom,
- Fig. 7: shows a capacitor bank as component as shown in Fig. 6 in accordance with the first and second embodiment as a perspective view laterally from the top, and
- Fig. 8: shows the capacitor bank of Fig. 7 in accordance with the first and second embodiment as inserted into the service opening of the power module, whereby the connection means are provided at a main PCB of the power module, as a lateral view.

### Detailed Description of the Invention

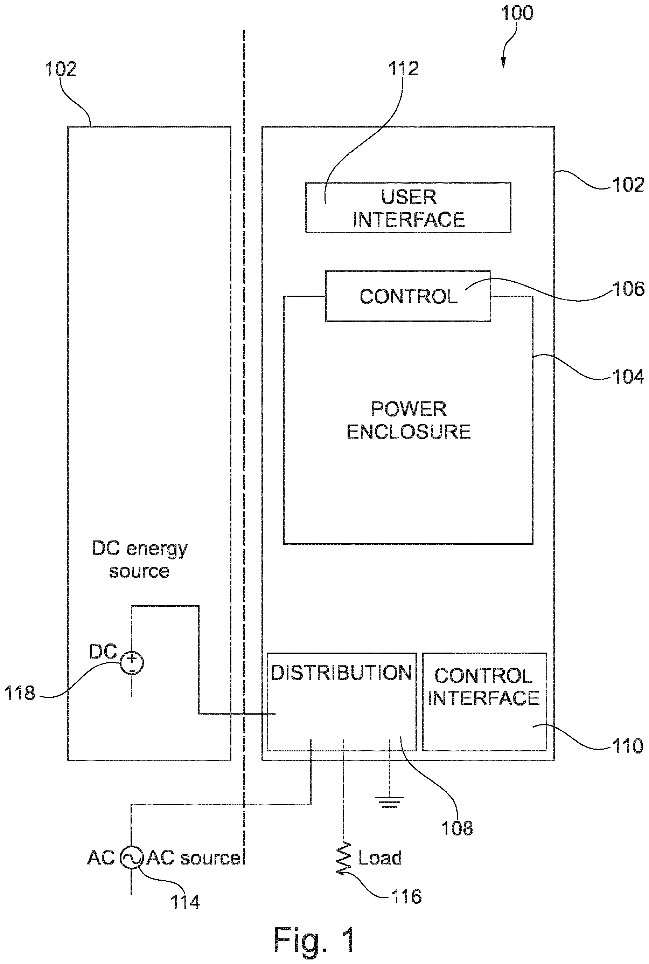

Fig. 1 shows a modular uninterruptible power supply (UPS) system 100 according to a first, preferred embodiment. The UPS system 100 comprises a system rack 102 for receiving a first, second and third module 104, 108, 118. The modules 104, 108, 118 in this embodiment are functional units of the UPS system 100.

The first module 104 is provided as power module 104. The power module 104 comprises a control panel 106. The second module 108 is provided as distribution assembly 108, and the third module 118 is provided as energy storage device 118, also referred to as DC energy source in the drawings. In an alternative embodiment, the UPS system 100 comprises multiple energy storage devices 118, which are electrically connected in parallel.

The UPS system 100 further comprises a control interface 110 and a user interface 112, as can be seen in Fig. 1. The UPS system 100 is connected via the distribution assembly 108 to ground, a AC power supply 114, and a load 116. The distribution assembly 108 also establishes a connection between the power module 104 and the energy storage device 118.

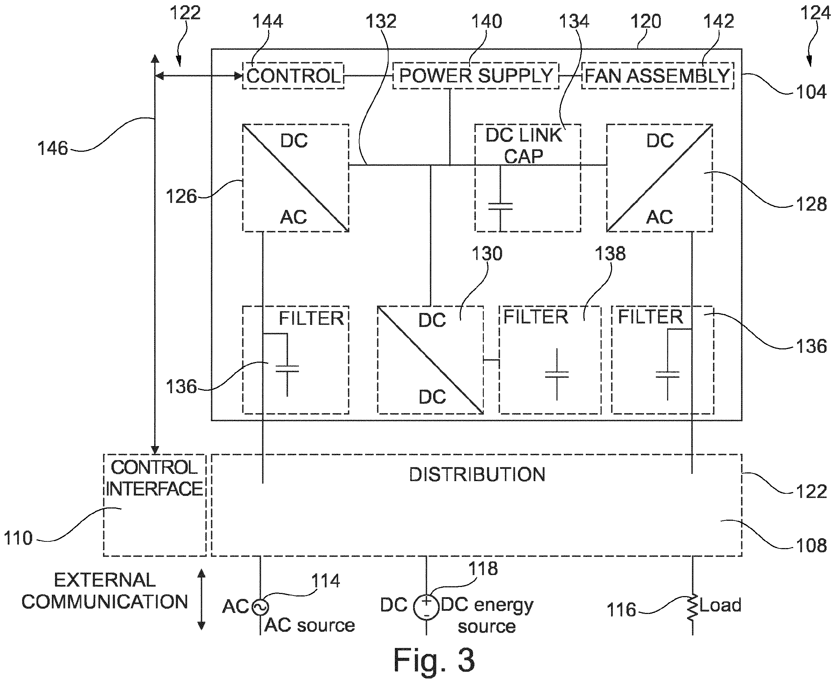

Fig. 3 shows the power module 104 together with the distribution assembly 108 in detail. The power module 104 comprises a housing 120. Further parts of the power module 104 are arranged within its housing 120.

The power module 104 further comprises an AC/DC converter unit 126, which is located at a power supply side 122 of the power module 104, a DC/AC converter unit 128, which is located at a load side 124 of the power module 104, and a DC/DC converter unit 130, which is connected to the energy storage device 118. The AC/DC converter unit 126, the DC/AC converter unit 128, and the DC/DC converter unit 130 are interconnected by a DC link 132.

The power module 104 further comprises a DC link capacitance 134, which is connected to the DC link 132, two AC filter 136, which are connected between the AC/DC converter unit 126 and the AC power supply 114 and between the DC/AC converter unit 128 and the load 116, respectively, and a DC filter 138, which is connected to the DC/DC converter unit 130.

The power module 104 also comprises a power supply 140, which is connected to a fan assembly 142 and a control unit 144 to provide power to the fan assembly 142 and the control unit 144. The fan assembly 142 is located at a rear side 143 of the housing 120 of the power module. The control unit 144 controls the operation of the entire power module 104 and is further connected to the control interface 110 via control bus 146.

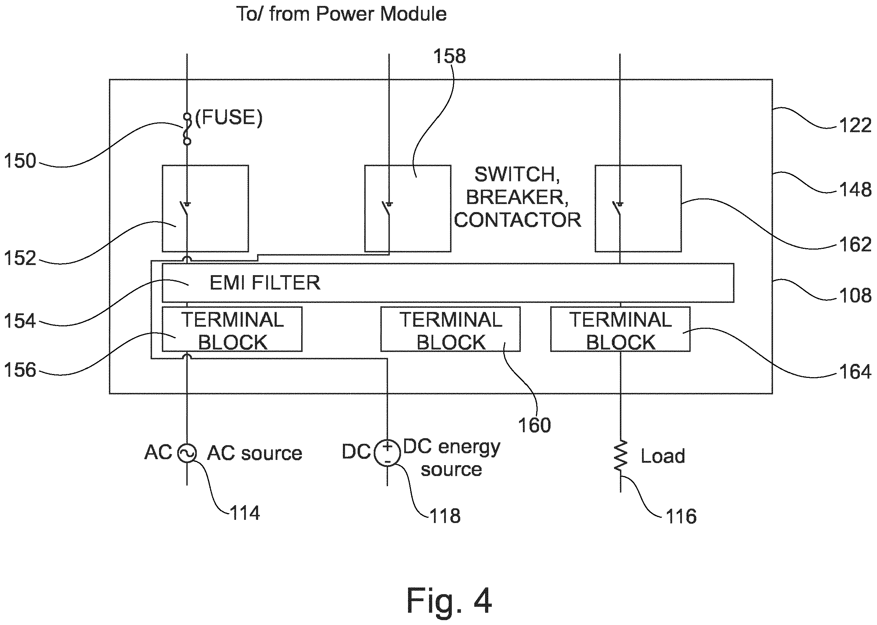

Fig. 4 shows the distribution assembly 108 in detail. The distribution assembly 108 comprises a housing 148. All further parts of the distribution assembly 108 are arranged within its housing 148.

The distribution assembly 108 comprises a fuse 150, a first switching device 152, an electromagnetic interference (EMI) filter 156, and a first terminal block 158, which are provided in series between the AC power supply 114 and the AC/DC converter unit 126. The distribution assembly 108 further comprises a second switching device 158, which is provided between the energy storage device 118 and the DC/DC converter unit 130. Optionally, a second terminal block 160 can be provided between the energy storage device 118 and the DC/DC converter unit 130, if a plug connection is desired. Since the energy storage device 118 and the DC/DC converter unit 130 are part of the UPS system 100, a hard wired connection is generally preferred. The distribution assembly 108 still further comprises a third switching device 162 and a third terminal block 164, which are provided in series between the load 116 and the DC/AC converter unit 128.

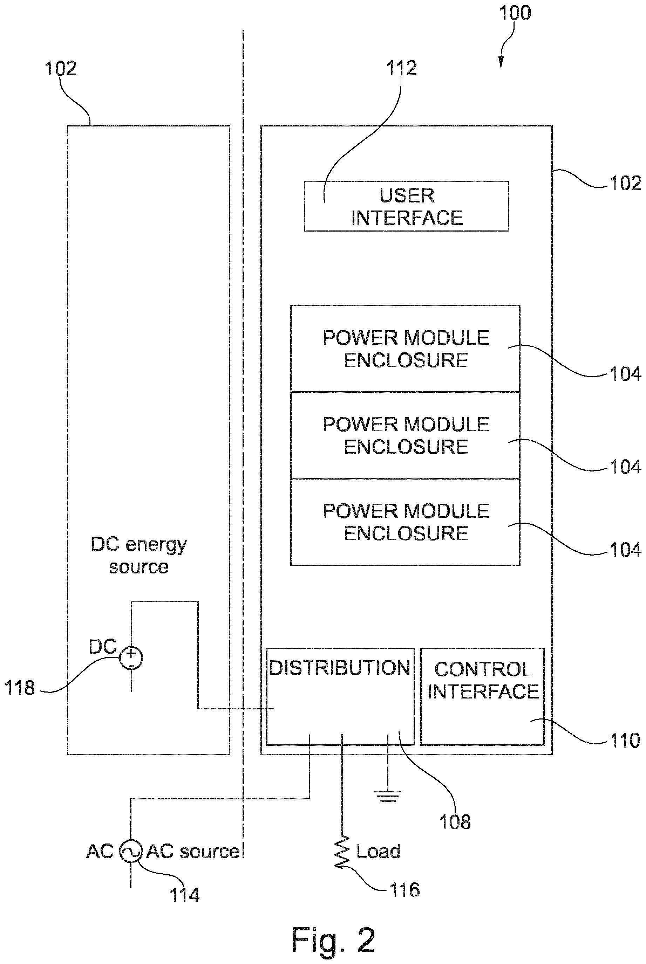

Fig. 2 shows a modular UPS system 100 according to a second embodiment. The UPS system 100 of the second embodiment is essentially identical to that of the first embodiment. Hence, a repeated discussion of the UPS system 100 of the second embodiment is omitted and only differences between the UPS systems 100 of the first and second embodiments are discussed.

As can be seen in Fig. 2, the UPS system 100 of the second embodiment differs from the UPS system 100 of the first embodiment in the number of power modules 104. The UPS system 100 of the second embodiment comprises three power modules 104, which are connected internally within the system rack 102 in parallel. Hence, the three power modules 104 are provided in parallel between the AC power supply 114 and the load 116.

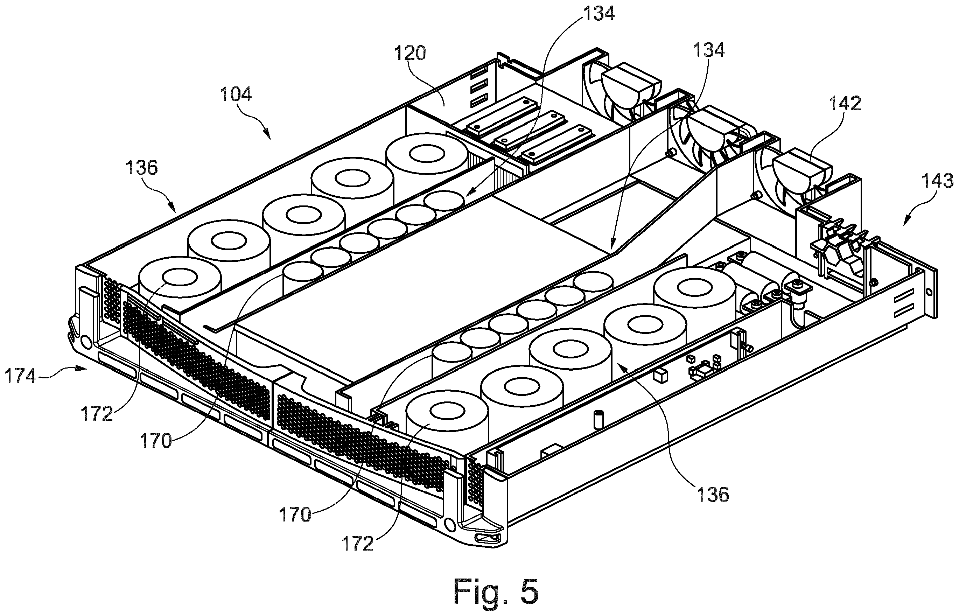

The general arrangement of components in the power modules 104 of the first and second embodiment can be seen in Fig. 5. Visible parts in the shown power module 104 are, as discussed above, provided in the housing 120 of the power module 104, which provides an enclosure for its components. The power module 104 has two capacitor banks 170, which correspond to the DC link capacitance 134. The power module 104 also has two capacitor banks 172, which correspond to the two AC filters 136. Furthermore, the fan assembly 142 is provided at the rear side 143 of the housing 120 of the power module 104, as discussed above.

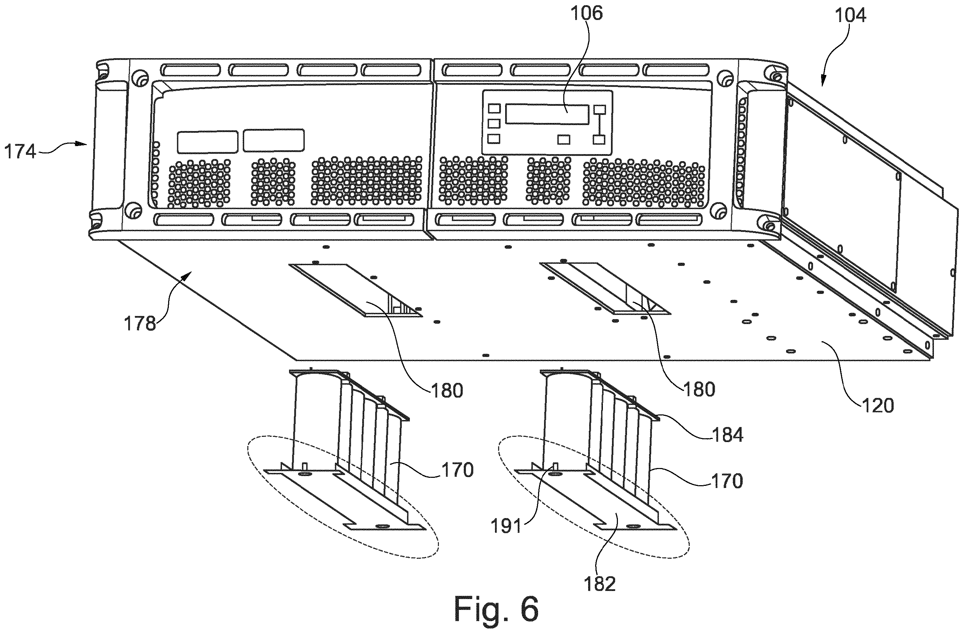

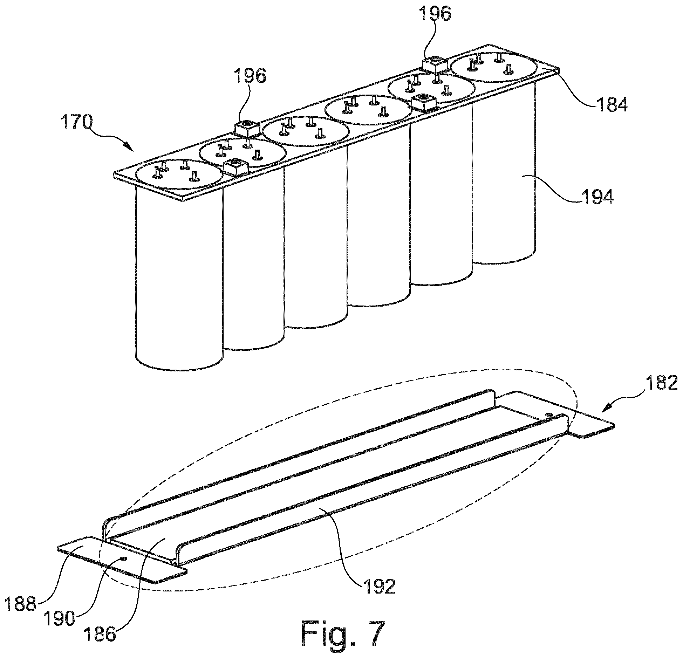

As can be seen in Fig. 6, the housing 120 of the power module 104 is shown by way of example with two service openings180 at its bottom side 178. The service openings 180 are arranged to remove and insert the capacitor banks 170 of the DC link 132 therethrough. The capacitor banks 170 of the DC link 132 are separately shown in Fig. 7. Hence, the capacitor banks 170 of the DC link 132 are removably connected within the housing 120 of the power module 104 and are components in the sense of the present invention. Although not explicitly shown in the figures, the same principles apply to the capacitor banks 172 of the AC filters 136. These components 170, 172 therefore form overall functional blocks, i.e. DC link capacitance 134 and AC filter 134, of the modular UPS system 100.

However, also other parts of the UPS system 100, which are typically subject to periodical and non-periodical maintenance, can be components in the sense of the present invention. This refers in particular to switches, batteries, further capacitors and other parts.

As can be further seen in Fig. 6, the control panel 106 is provided at a front side 174 of the housing of the power module 104. Rear side 143 and front side 174 walls of the housing 120 are accessible when the power module 104 is in an inserted position within the system rack 102. Hence, components accessible from the rear side 143 and front side 174 can be inserted and/or removed without the necessity to remove the power module 104 from the system rack 102.

The capacitor banks 170 of the DC link 132 comprise a cover 182 and a component printed circuit board (PCB) 184, on which individual capacitors 194 of the capacitor banks 170 are mounted. The cover 182 is provided opposite to the component PCB 184 and is connected via a thermally conductive carpet 186 to the individual capacitors 194. Hence, the thermally conductive carpet 186 is considered as thermal conduction means in the sense of the present invention, since it is in thermal contact with the individual capacitors 194 to dissipate heat.

The cover 182 is provided with lateral mounting latches 188, which have holes 190, and sidewalls 192. The capacitor banks 170 of the DC link 132 can be fixed to the housing 120 of the power module 104 with screws 191, which are inserted through the holes 190 and screwed into the housing 120 of the power module 104. Hence, the cover 182 provides a sealing of the service opening 180 with ingress protection to the service opening 180 and therefore is a sealing means in the sense of the present invention. The capacitor bank 170 of the DC link 132 is provided with connection means 196 at the component PCB 184 for mounting on the module PCB 200 of the power module 104, which are adapted to ensure mechanical connection of the capacitor bank 170 of the DC link 132 in the service opening 180 in a pre-defined way based on their positioning on the component PCB 184.

Insertion of the capacitor bank 170 of the DC link 132 is facilitated by the design of the dimensions of the service opening 180 and a physical space within the housing 120 of the power module 104, which are designed to form fit with the capacitor bank 170 of the DC link 132.

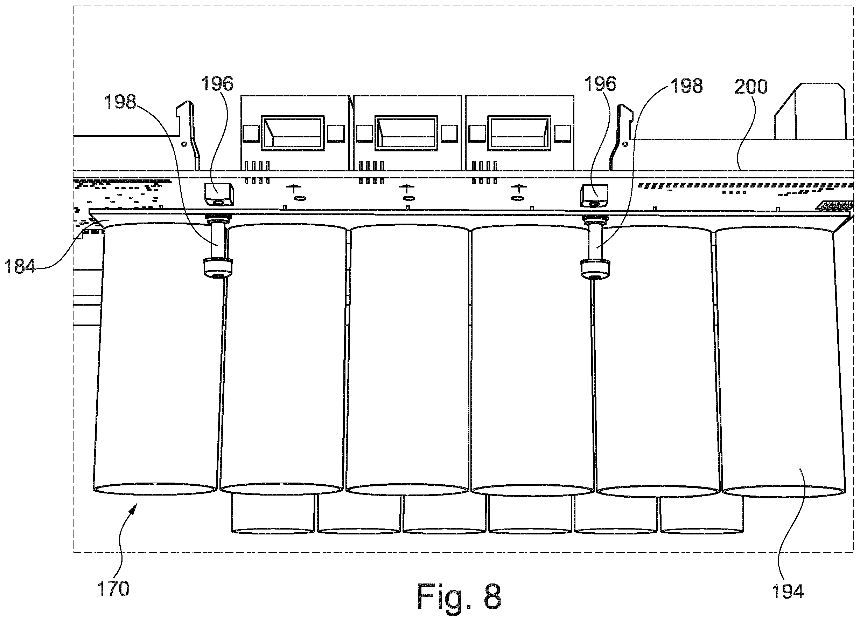

As can be seen in Fig. 8 in detail, the capacitor bank 170 of the DC link 132 is removably connected within the housing 120 of the power module 104 with its component PCB 184 to a module printed circuit board (PCB) 200 of the power module 104. It is to be noted that as a slight deviation from the capacitor bank 170 of the DC link 132 of Fig. 7, the capacitor bank 170 of the DC link 132 as shown in Fig. 8 is provided without connection means 196 at the component PCB 184. In this embodiment, the connection means 196 for mounting on the module PCB 200 of the power module 104 are provided on the module PCB 200. Also in this embodiment the connection means 196 are adapted to ensure mechanical connection of the capacitor bank 170 of the DC link 132 in the service opening 180 in a pre-defined way.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings and the description, without depart from the appended claims. In the claims, the word "comprising" does not exclude other elements or steps, and the indefinite article "a" or "an" does not exclude a plurality. Any reference signs in the claims should not be construed as limiting scope.

### Reference signs list

- 100: uninterruptible power supply system
- 102: system rack
- 104: power module, first module
- 106: control panel
- 108: distribution assembly, second module
- 110: control interface
- 112: user interface
- 114: AC power supply
- 116: load
- 118: energy storage device, DC energy source, third module
- 120: housing (power module)
- 122: power supply side
- 124: load side
- 126: AC/DC converter unit, rectifier
- 128: DC/AC converter unit, inverter
- 130: DC/DC converter unit
- 132: DC link
- 134: DC link capacitance
- 136: AC filter
- 138: DC filter
- 140: power supply
- 142: fan assembly
- 143: rear side
- 144: control unit
- 146: control bus
- 148: housing (distribution assembly)
- 150: fuse
- 152: first switching device, functional disconnect
- 154: electromagnetic interference (EMI) filter
- 156: first terminal block
- 158: second switching device, functional disconnect
- 160: second terminal block
- 162: third switching device, functional disconnect
- 164: third terminal block
- 170: capacitor bank (DC link), component
- 172: capacitor bank (AC filter), component
- 174: front side
- 178: bottom side
- 180: service opening
- 182: cover, sealing means
- 184: component printed circuit board
- 186: thermally conductive carpet, thermal conduction means
- 188: mounting latch
- 190: hole
- 191: screw
- 192: sidewall
- 194: capacitor
- 196: connection means
- 198: mounting screw
- 200: module printed circuit board

## Claims

1. A modular uninterruptible power supply system (100) comprising a system rack (102) for receiving at least one module (104, 108, 118) with a functional unit of the uninterruptible power supply system (100), whereby
the at least one module (104, 108, 118) comprises a housing (120, 148), and
the at least one module (104, 108, 118) is one out of
a power module (104),
energy storage device (118), and
a distribution assembly (108),
wherein
the at least one module (104, 108, 118) comprises at least one component (170, 172), which is removably connected within the housing (120, 148) of the respective module (104, 108, 118),
the housing (120, 148) has at least one service opening (180), and
the at least one service opening (180) is arranged to remove and/or insert the at least one component (170, 172) through the at least one service opening (180)
**characterized in that**
the at least one component (170, 172) and/or the at least one service opening (180) comprise detection means, which are adapted to detect an electrical and/or mechanical connection of the at least one component (170, 172) in the at least one service opening (180) in a pre-defined way, and **in that** the modular uninterruptible power supply system (100) is adapted to changing into a safe system state upon a detection of the detection means of an electrical and/or mechanical connection of the at least one component (170, 172) in the at least one service opening (180) different than in the pre-defined way.

2. Modular uninterruptible power supply system (100) according to claim 1,
**characterized in that**
the at least one component (170, 172) forms an overall functional block of the modular uninterruptible power supply system (100).

3. Modular uninterruptible power supply system (100) according to preceding claims 1 or 2,
**characterized in that**
the at least one component (170, 172) is one out of
a total DC link capacitance (134) or a subset, e.g. a rail of a multi-rail DC link (132),
a filter capacitance of at least one power module function, e.g. AC/DC converter unit (126), a DC/DC converter unit (130), or a DC/AC converter unit (128),
a functional disconnect (152, 158, 162) for e.g. an AC/DC converter unit (126), a DC/DC converter unit (130), or a DC/AC converter unit (128),
a system sub-function, e.g. an auxiliary power supply,
a cooling device, e.g. a fan assembly (142) or a thermal exchanger,
a printed circuit board (184) with a specific function within the UPS system (100), or
any combination of the above functionality.

4. Modular uninterruptible power supply system (100) according to any of preceding claims 1 to 3,
**characterized in that**
the at least one component (170, 172) comprises a component printed circuit board (184), and the at least one component (170, 172) is removably connected within the housing (120, 148) with its component printed circuit board (184).

5. Modular uninterruptible power supply system (100) according to any preceding claim,
**characterized in that**
the at least one component and (170, 172) the at least one service opening (180) comprise corresponding insertion means, which are adapted to ensure insertion of the at least one component (170, 172) into the at least one service opening (180) in a pre-defined way.

6. Modular uninterruptible power supply system (100) according to any preceding claim,
**characterized in that**
the at least one component (170, 172) and the at least one service opening (180) comprise corresponding connection means (196), which are adapted to ensure electrical and/or mechanical connection of the at least one component (170, 172) in the at least one service opening (180) in a pre-defined way.

7. Modular uninterruptible power supply system (100) according to preceding claim 7,
**characterized in that**
the modular uninterruptible power supply system (100) comprises a user interface (112) and a control unit (144), which is connected to the detection means, whereby
control unit (144) is adapted to indicate a detection of the detection means of an electrical and/or mechanical connection of the at least one component (170, 172) in the at least one service opening (180) in a pre-defined way, or vice versa, via the user interface (112).

8. Modular uninterruptible power supply system (100) according to preceding claim 1,
**characterized in that**
the modular uninterruptible power supply system (100) is adapted to perform at least one of the steps of opening of a controlled switch gear, turning off a converter unit (126, 128, 130) of the power module (104) and turning off a sub-function of the power module (104) upon changing into a safe system state.

9. Modular uninterruptible power supply system (100) according to any preceding claim,
**characterized in that**
the service opening (180) comprises sealing means (182), which provide ingress protection to the service opening (180).

10. Modular uninterruptible power supply system (100) according to any preceding claim,
**characterized in that**
the component (170, 172) comprises an enclosure, which provides protection to elements of the component (170, 172).

11. Modular uninterruptible power supply system (100) according to any preceding claim,
**characterized in that**
the at least one service opening (180) is arranged in a wall of the housing (120, 148), which is accessible when the module (104, 108, 118) is in an inserted position within the system rack (102).

12. Modular uninterruptible power supply system (100) according to any preceding claim,
**characterized in that**
the at least one component (170, 172) is a calibrated component (170, 172), which is calibrated to a pre-defined accuracy for at least one of a given current, voltage, temperature or other measurement circuitry included, in particular the component (170, 172) is calibrated to multiple pre-defined accuracies for at least one of a given current, voltage, temperature or other measurement circuitry included.

13. Modular uninterruptible power supply system (100) according to any preceding claim,
**characterized in that**
the at least one service opening (180) is provided having thermal conduction means (186), which are in thermal contact with the at least one component (170, 172) when inserted in the at least one service opening (180).

## Patentansprüche

1. Modulares unterbrechungsfreies Stromversorgungssystem (100), umfassend ein Anlagengestell (102) zum Aufnehmen mindestens eines Moduls (104, 108, 118) mit einer Funktionseinheit des unterbrechungsfreien Stromversorgungssystems (100), wodurch
das mindestens eine Modul (104, 108, 118) ein Gehäuse (120, 148) umfasst und
es sich bei dem mindestens einen Modul (104, 108, 118) um entweder
ein Leistungsmodul (104),
eine Energiespeichereinrichtung (118) oder
eine Verteilungsanordnung (108) handelt,
wobei
das mindestens eine Modul (104, 108, 118) mindestens eine Komponente (170, 172) umfasst, die entfernbar im Gehäuse (120, 148) des jeweiligen Moduls (104, 108, 118) verbunden ist,
das Gehäuse (120, 148) mindestens eine Wartungsöffnung (180) aufweist und
die mindestens eine Wartungsöffnung (180) dafür eingerichtet ist, die mindestens eine Komponente (170, 172) durch die mindestens eine Wartungsöffnung (180) zu entnehmen und/oder einzusetzen,
**dadurch gekennzeichnet, dass**
die mindestens eine Komponente (170, 172) und/oder die mindestens eine Wartungsöffnung (180) Erfassungsmittel umfassen, die dafür ausgelegt sind, eine elektrische und/oder mechanische Verbindung der mindestens einen Komponente (170, 172) in der mindestens einen Wartungsöffnung (180) in einer vorab definierten Weise zu erfassen, und dass das modulare unterbrechungsfreie Stromversorgungssystem (100) dafür ausgelegt ist, nach einer durch die Erfassungsmittel erfolgten Erfassung einer elektrischen und/oder mechanischen Verbindung der mindestens einen Komponente (170, 172) in der mindestens einen Wartungsöffnung (180) in einer anderen als der vorab definierten Weise in einen sicheren Systemzustand zu wechseln.

2. Modulares unterbrechungsfreies Stromversorgungssystem (100) nach Anspruch 1,
**dadurch gekennzeichnet, dass**
die mindestens eine Komponente (170, 172) einen Gesamtfunktionsblock des modularen unterbrechungsfreien Stromversorgungssystems (100) bildet.

3. Modulares unterbrechungsfreies Stromversorgungssystem (100) nach einem der vorhergehenden Ansprüche 1 oder 2,
**dadurch gekennzeichnet, dass**
es sich bei der mindestens einen Komponente (170, 172) um entweder
eine Gleichstromzwischenkreis-Gesamtkapazität (134) oder eine Teileinheit, z.B. eine Schiene eines Mehrschienen-Gleichstromzwischenkreises (132),
eine Filterkapazität mindestens einer Leistungsmodulfunktion, z.B. einer Wechselstrom-Gleichstromumrichtereinheit (126), einer Gleichstromumrichtereinheit (130) oder einer Gleichstrom-Wechselstromumrichtereinheit (128),
eine funktionelle Trennung (152, 158, 162) für z.B. eine Wechselstrom-Gleichstromumrichtereinheit (126), eine Gleichspannungswandler (130) oder eine Gleichstrom-Wechselstromumrichtereinheit (128),
eine Systemteilfunktion, z.B. eine Hilfsleistungsquelle, eine Kühleinrichtung, z.B. eine Gebläseanordnung (142) oder einen Wärmetauscher,
eine Leiterplatte (184) mit einer spezifischen Funktion innerhalb des USV-Systems (100) oder
eine Kombination der vorstehenden Funktionen handelt.

4. Modulares unterbrechungsfreies Stromversorgungssystem (100) nach einem der vorhergehenden Ansprüche 1 bis 3,
**dadurch gekennzeichnet, dass**
die mindestens eine Komponente (170, 172) eine Komponentenleiterplatte (184) umfasst und die mindestens eine Komponente (170, 172) mit ihrer Komponentenleiterplatte (184) entfernbar innerhalb des Gehäuses (120, 148) verbunden ist.

5. Modulares unterbrechungsfreies Stromversorgungssystem (100) nach einem der vorhergehenden Ansprüche,
**dadurch gekennzeichnet, dass**
die mindestens eine Komponente (170, 172) und die mindestens eine Wartungsöffnung (180) entsprechende Einsetzmittel umfassen, die dafür ausgelegt sind, ein Einsetzen der mindestens einen Komponente (170, 172) in die mindestens eine Wartungsöffnung (180) in einer vorab definierten Weise sicherzustellen.

6. Modulares unterbrechungsfreies Stromversorgungssystem (100) nach einem der vorhergehenden Ansprüche,
**dadurch gekennzeichnet, dass**
die mindestens eine Komponente (170, 172) und die mindestens eine Wartungsöffnung (180) entsprechende Verbindungsmittel (196) umfassen, die dafür ausgelegt sind, eine elektrische und/oder mechanische Verbindung der mindestens einen Komponente (170, 172) in der mindestens einen Wartungsöffnung (180) in einer vorab definierten Weise sicherzustellen.

7. Modulares unterbrechungsfreies Stromversorgungssystem (100) nach dem vorhergehenden Anspruch 7,
**dadurch gekennzeichnet, dass**
das modulare unterbrechungsfreie Stromversorgungssystem (100) eine Nutzerschnittstelle (112) und eine Steuereinheit (144) umfasst, die mit den Erfassungsmitteln verbunden ist, wodurch die Steuereinheit (144) dafür ausgelegt ist, über die Nutzerschnittstelle (112) eine durch die Erfassungsmittel erfolgte Erfassung einer elektrischen und/oder mechanischen Verbindung der mindestens einen Komponente (170, 172) in der mindestens einen Wartungsöffnung (180) in einer vorab definierten Weise oder umgekehrt anzuzeigen.

8. Modulares unterbrechungsfreies Stromversorgungssystem (100) nach dem vorhergehenden Anspruch 1,
**dadurch gekennzeichnet, dass**
das modulare unterbrechungsfreie Stromversorgungssystem (100) dafür ausgelegt ist, nach einem Wechseln in einen sicheren Systemzustand mindestens einen der Schritte eines Öffnens einer gesteuerten Schaltanlage, eines Ausschaltens einer Umrichtereinheit (126, 128, 130) des Leistungsmoduls (104) und eines Ausschaltens einer Teilfunktion des Leistungsmoduls (104) durchzuführen.

9. Modulares unterbrechungsfreies Stromversorgungssystem (100) nach einem der vorhergehenden Ansprüche,
**dadurch gekennzeichnet, dass**
die Wartungsöffnung (180) Dichtungsmittel (182) umfasst, die für die Wartungsöffnung (180) einen Eindringschutz bereitstellen.

10. Modulares unterbrechungsfreies Stromversorgungssystem (100) nach einem der vorhergehenden Ansprüche,
**dadurch gekennzeichnet, dass**
die Komponente (170, 172) eine Umhüllung umfasst, die einen Schutz für Elemente der Komponente (170, 172) bereitstellt.

11. Modulares unterbrechungsfreies Stromversorgungssystem (100) nach einem der vorhergehenden Ansprüche,
**dadurch gekennzeichnet, dass**
die mindestens eine Wartungsöffnung (180) in einer Wand des Gehäuses (120, 148) angeordnet ist, die zugänglich ist, wenn sich das Modul (104, 108, 118) in einer in das Anlagengestell (102) eingesetzten Position befindet.

12. Modulares unterbrechungsfreies Stromversorgungssystem (100) nach einem der vorhergehenden Ansprüche,
**dadurch gekennzeichnet, dass**
es sich bei der mindestens einen Komponente (170, 172) um eine kalibrierte Komponente (170, 172) handelt, die für mindestens eines von gegebenem Strom, Spannung, Temperatur oder einer anderen enthaltenen Messschaltung auf eine vorab definierte Genauigkeit kalibriert ist, wobei insbesondere die Komponente (170, 172) für mindestens eines von gegebenem Strom, Spannung, Temperatur oder einer anderen enthaltenen Messschaltung auf mehrere vorab definierte Genauigkeiten kalibriert ist.

13. Modulares unterbrechungsfreies Stromversorgungssystem (100) nach einem der vorhergehenden Ansprüche,
**dadurch gekennzeichnet, dass**
die mindestens eine Wartungsöffnung (180) mit Wärmeleitmitteln (186) versehen ist, die mit der mindestens einen Komponente (170, 172) in Wärmekontakt stehen, wenn diese in die mindestens eine Wartungsöffnung (180) eingesetzt ist.

## Revendications

1. Un système d'alimentation électrique sans interruption modulaire (100) comprenant un châssis (102) de système destiné à recevoir au moins un module (104, 108, 118) avec une unité fonctionnelle du système d'alimentation électrique sans interruption (100), moyennant quoi
l'au moins un module (104, 108, 118) comprend un boîtier (120, 148), et
l'au moins un module (104, 108, 118) constitue l'un des éléments suivants
un module de puissance (104),
un dispositif de stockage d'énergie (118), et
un ensemble de distribution (108),
l'au moins un module (104, 108, 118) comprenant au moins un composant (170, 172), lequel est connecté de façon amovible à l'intérieur du boîtier (120, 148) du module respectif (104, 108, 118),
le boîtier (120, 148) présentant au moins une ouverture de maintenance (180), et
l'au moins une ouverture de maintenance (180) étant ménagée pour permettre le retrait et/ou l'insertion de l'au moins un composant (170, 172) par l'au moins une ouverture de maintenance (180),
**caractérisé en ce que**
l'au moins un composant (170, 172) et/ou l'au moins une ouverture de maintenance (180) comprennent/comprend des moyens de détection, lesquels sont adaptés à détecter une connexion électrique et/ou mécanique de l'au moins un composant (170, 172) dans l'au moins une ouverture de maintenance (180) dans un mode prédéfini, et **en ce que** le système d'alimentation électrique sans interruption modulaire (100) est adapté à passer dans un état de sûreté système lors d'une détection, par les moyens de détection, d'une connexion électrique et/ou mécanique de l'au moins un composant (170, 172) dans l'au moins une ouverture de maintenance (180) différente de celle dans le mode prédéfini.

2. Système d'alimentation électrique sans interruption modulaire (100) selon la revendication 1,
**caractérisé en ce que**
l'au moins un composant (170, 172) forme un bloc fonctionnel global du système d'alimentation électrique sans interruption modulaire (100).

3. Système d'alimentation électrique sans interruption modulaire (100) selon les revendications 1 et 2 précédentes,
**caractérisé en ce que**
l'au moins un composant (170, 172) constitue l'un des éléments suivants
une capacité de liaison en courant continu totale (134) ou un sous-ensemble, par ex. un rail d'une liaison en courant continu à rails multiples (132),
une capacité de filtre d'au moins une fonction de module de puissance, par ex. une unité de conversion alternatif/continu (126), une unité de conversion continu/continu (130) ou une unité de conversion continu/alternatif (128),
une déconnexion fonctionnelle (152, 158, 162) pour, par ex., une unité de conversion alternatif/continu (126), une unité de conversion continu/continu (130) ou une unité de conversion continu/alternatif (128),
une sous-fonction système, par ex. une alimentation électrique auxiliaire,
un dispositif de refroidissement, par ex. un ensemble ventilateur (142) ou un échangeur thermique,
une carte de circuit imprimé (184) remplissant une fonction particulière au sein du système UPS (100), ou
toute combinaison de la fonctionnalité ci-dessus.

4. Système d'alimentation électrique sans interruption modulaire (100) selon l'une quelconque des revendications 1 à 3 précédentes,
**caractérisé en ce que**
l'au moins un composant (170, 172) comprend une carte de circuit imprimé (184) de composant, et l'au moins un composant (170, 172) est connecté de façon amovible à l'intérieur du boîtier (120, 148) à sa carte de circuit imprimé (184) de composant.

5. Système d'alimentation électrique sans interruption modulaire (100) selon l'une quelconque des revendications précédentes,
**caractérisé en ce que**
l'au moins un composant (170, 172) et l'au moins une ouverture de maintenance (180) comprennent des moyens d'insertion correspondants, lesquels sont adaptés à assurer l'insertion de l'au moins un composant (170, 172) dans l'au moins une ouverture de maintenance (180) dans un mode prédéfini.

6. Système d'alimentation électrique sans interruption modulaire (100) selon l'une quelconque des revendications précédentes,
**caractérisé en ce que**
l'au moins un composant (170, 172) et l'au moins une ouverture de maintenance (180) comprennent des moyens de connexion correspondants (196), lesquels sont adaptés à assurer la connexion électrique et/ou mécanique de l'au moins un composant (170, 172) dans l'au moins une ouverture de maintenance (180) dans un mode prédéfini.

7. Système d'alimentation électrique sans interruption modulaire (100) selon la revendication 7 précédente,
**caractérisé en ce que**
le système d'alimentation électrique sans interruption modulaire (100) comprend une interface-utilisateur (112) et une unité de commande (144), laquelle est connectée aux moyens de détection, moyennant quoi
l'unité de commande (144) est adaptée à indiquer une détection, par les moyens de détection, d'une connexion électrique et/ou mécanique de l'au moins un composant (170, 172) dans l'au moins une ouverture de maintenance (180) dans un mode prédéfini, ou vice-versa, par le biais de l'interface-utilisateur (112) .

8. Système d'alimentation électrique sans interruption modulaire (100) selon la revendication 1 précédente,
**caractérisé en ce que**
le système d'alimentation électrique sans interruption modulaire (100) est adapté à accomplir au moins une étape parmi les étapes d'ouverture d'un appareil de commutation commandé, de coupure d'une unité de conversion (126, 128, 130) du module de puissance (104) et de coupure d'une sous-fonction du module de puissance (104) lors du passage dans un état de sûreté système.

9. Système d'alimentation électrique sans interruption modulaire (100) selon l'une quelconque des revendications précédentes,
**caractérisé en ce que**
l'ouverture de maintenance (180) comprend des moyens d'étanchéité (182), lesquels procurent une protection anti-intrusion à l'ouverture de maintenance (180) .

10. Système d'alimentation électrique sans interruption modulaire (100) selon l'une quelconque des revendications précédentes,
**caractérisé en ce que**
le composant (170, 172) comprend une enveloppe, laquelle procure une protection à des éléments du composant (170, 172).

11. Système d'alimentation électrique sans interruption modulaire (100) selon l'une quelconque des revendications précédentes,
**caractérisé en ce que**
l'au moins une ouverture de maintenance (180) est ménagée dans une paroi du boîtier (120, 148), laquelle est accessible lorsque le module (104, 108, 118) se trouve dans une position insérée à l'intérieur du châssis (102) de système.

12. Système d'alimentation électrique sans interruption modulaire (100) selon l'une quelconque des revendications précédentes,
**caractérisé en ce que**
l'au moins un composant (170, 172) est un composant calibré (170, 172), lequel est calibré à une précision prédéfinie pour au moins un montage de circuits de mesure parmi des montages de circuits de mesure donnés de courant, de tension, de température ou d'un autre paramètre qui sont incorporés, plus particulièrement le composant (170, 172) est calibré à de multiples précisions prédéfinies pour au moins un montage de circuits de mesure parmi des montages de circuits de mesure donnés de courant, de tension, de température ou d'un autre paramètre qui sont incorporés.

13. Système d'alimentation électrique sans interruption modulaire (100) selon l'une quelconque des revendications précédentes,
**caractérisé en ce que**
l'au moins une ouverture de maintenance (180) est pourvue de moyens de conduction thermique (186), lesquels sont au contact thermique de l'au moins un composant (170, 172) lorsque celui-ci est inséré dans l'au moins une ouverture de maintenance (180).
